(19) Europäisches Patentamt
European Patent Office
Office européen des brevets

(11) **EP 1 102 334 B1**

(12) **EUROPÄISCHE PATENTSCHRIFT**

(45) Veröffentlichungstag und Bekanntmachung des Hinweises auf die Patenterteilung:
**12.01.2011 Patentblatt 2011/02**

(51) Int Cl.:
*H01L 35/16* *(2006.01)*     *H01L 35/22* *(2006.01)*
*C01G 43/00* *(2006.01)*     *C01G 29/00* *(2006.01)*
*C01B 19/00* *(2006.01)*     *C01F 11/00* *(2006.01)*
*C01G 45/00* *(2006.01)*     *C01G 49/00* *(2006.01)*
*C01G 51/00* *(2006.01)*     *C01G 17/00* *(2006.01)*
*C01G 21/00* *(2006.01)*     *C01G 23/00* *(2006.01)*
*C01G 25/00* *(2006.01)*     *C01G 37/00* *(2006.01)*
*C01G 39/00* *(2006.01)*     *C01G 41/00* *(2006.01)*
*C22C 32/00* *(2006.01)*

(21) Anmeldenummer: 00124259.3

(22) Anmeldetag: **13.11.2000**

(54) **Thermoelektrisch aktive Materialien und diese enthaltende Generatoren**

Thermoelectric active materials and generators containing the same

Matériaux thermoélectriques actifs et générateurs les contenant

(84) Benannte Vertragsstaaten:
**BE DE FR GB NL**

(30) Priorität: **19.11.1999 DE 19955788**

(43) Veröffentlichungstag der Anmeldung:
**23.05.2001 Patentblatt 2001/21**

(60) Teilanmeldung:
**10182070.2 / 2 270 890**
**10182075.1**

(73) Patentinhaber: **BASF SE**
**67056 Ludwigshafen (DE)**

(72) Erfinder: **Sterzel, Hans-Josef, Dr.**
**67125 Dannstadt-Schauernheim (DE)**

(56) Entgegenhaltungen:
EP-A- 0 522 182     DE-B- 1 128 672
GB-A- 1 118 184     US-A- 3 208 878
US-A- 3 256 702     US-A- 3 407 037
US-A- 3 940 472     US-A- 4 545 967

• PATENT ABSTRACTS OF JAPAN vol. 016, no. 403 (E-1254), 26. August 1992 (1992-08-26) & JP 04 133481 A (UBE IND LTD;OTHERS: 01), 7. Mai 1992 (1992-05-07)
• PATENT ABSTRACTS OF JAPAN vol. 1999, no. 03, 31. März 1999 (1999-03-31) & JP 10 317086 A (HITACHI LTD), 2. Dezember 1998 (1998-12-02)
• KAJIKAWA T ET AL: "Thermoelectric properties of magnesium silicide processed by powdered elements plasma activated sintering method" THERMOELECTRICS, 1997. PROCEEDINGS ICT '97. XVI INTERNATIONAL CONFERENCE ON DRESDEN, GERMANY 26-29 AUG. 1997, NEW YORK, NY, USA,IEEE, US, 26. August 1997 (1997-08-26), Seiten 275-278, XP010275113 ISBN: 0-7803-4057-4
• PATENT ABSTRACTS OF JAPAN vol. 1999, no. 10, 31. August 1999 (1999-08-31) & JP 11 135840 A (SUMITOMO SPECIAL METALS CO LTD), 21. Mai 1999 (1999-05-21)
• DATABASE WPI Section Ch, Week 197428 Derwent Publications Ltd., London, GB; Class L03, AN 1974-51239V XP002269934 & JP 49 023634 B (ANRITSU ELECTRIC CO LTD) , 17. Juni 1974 (1974-06-17)

EP 1 102 334 B1

**Beschreibung**

Die Erfindung betrifft thermoelektrisch aktive Materialien und diese enthaltende Generatoren sowie Verfahren zur Herstellung der thermoelektrisch aktiven Materialien.

Thermoelektrische Generatoren als solche sind seit langem bekannt. p- und n- dotierte Halbleiter, die auf einer Seite erhitzt und auf der anderen Seite gekühlt werden, transportieren elektrische Ladungen durch einen äußeren Stromkreis, an einem Verbraucher im Stromkreis wird dabei elektrische Arbeit verrichtet. Der dabei erzielte Wirkungsgrad der Konversion von Wärme in elektrische Energie wird thermodynamisch durch den Carnot - Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Leider werden bis heute nur Wirkungsgrade bis 10 % erzielt.

Einen guten Überblick über Effekte und Materialien gibt z. B. Cronin B. Vining, ITS Short Course on Thermoelectricity, Nov. 8, 1993 Yokohama, Japan.

Gegenwärtig werden thermoelektrische Generatoren in Raumsonden zur Erzeugung von Gleichströmen, für den kathodischen Korrosionsschutz von Pipelines, zur Energieversorgung von Leucht- und Funkbojen, zum Betrieb von Radios und Fernsehapparaten eingesetzt. Die Vorteile der thermoelektrischen Generatoren liegen in ihrer äußersten Zuverlässigkeit, sie arbeiten unabhängig von atmosphärischen Bedingungen wie Luftfeuchte, es erfolgt kein störungsanfälliger Stofftransport, sondern nur ein Ladungstransport; der Betriebsstoff wird kontinuierlich - auch katalytisch ohne freie Flamme- verbrannt, wodurch nur geringe Mengen an CO, $NO_x$ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit paßt sich die thermoelektrische Energiewandlung äußerst flexibel in künftige Bedürfnisse wie Wasserstoffwirtschaft oder Energieerzeugung aus regenerativen Energien ein.

Eine besonders attraktive Anwendung wäre der Einsatz zur Wandlung in elektrische Energie in elektrisch betriebenen Fahrzeugen. Es brauchte keine Änderung am vorhandenen Tankstellennetz vorgenommen zu werden. Für eine derartige Anwendung wären jedoch Wirkungsgrade größer als 30 % notwendig.

Die Aufgabe der Erfindung besteht deshalb darin, neue, thermoelektrisch aktive Materialien zur Verfügung zu stellen, die höhere Wirkungsgrade als bisher ermöglichen. Kennzeichnend für thermoelektrische Materialien ist der sogenannte Z-Faktor (figure of merit)

$$Z = \frac{\alpha^2 * \sigma}{K}$$

mit dem Seebeck - Koeffizienten $\alpha$, der elektrischen Leitfähigkeit $\sigma$ und der Wärmeleitfähigkeit K.

Eine genauere Analyse ergibt, daß der Wirkungsgrad $\eta$ sich ergibt aus

$$\eta = \frac{T_{hoch} - T_{niedrieg}}{T_{hoch}} * \frac{M - 1}{M + \dfrac{T_{hoch}}{T_{niedrieg}}}$$

mit $M = \left[1 + \frac{Z}{2}\ (T_{hoch} - T_{niedig})\right]^{\frac{1}{2}}$

(siehe auch Mat. Sci. and Eng. B29 (1995) 228).

Das Ziel ist damit, ein Material mit einem möglichst hohen Wert für Z und hoher realisierbarer Temperaturdifferenz bereitzustellen. Aus der Sicht der Festkörperphysik sind hierbei viele Probleme zu bewältigen:

Ein hohes $\alpha$ bedingt eine hohe Elektronenbeweglichkeit im Material; d.h. Elektronen (oder Löcher bei p-leitenden Materialien) dürfen nicht stark an die Atomrümpfe gebunden sein. Materialien mit hoher elektrischer Leitfähigkeit weisen meist gleichzeitig eine hohe Wärmeleitfähigkeit auf (Wiedemann - Franzsches Gesetz), wodurch Z nicht günstig beeinflußt werden kann. Gegenwärtig eingesetzte Materialien wie $Bi_2Te_3$, PbTe oder SiGe stellen schon Kompromisse dar. So wird die elektrische Leitfähigkeit durch Legieren weniger herabgesetzt als die Wärmeleitfähigkeit. Deshalb setzt man vorzugsweise Legierungen ein wie z. B. $(Bi_2T_3)_{90}\ (Sb_2T_3)_5\ (Sb_2Se_3)_5$ oder $Bi_{12}\ Sb_{23}\ Te_{65}$, wie sie in der US 5, 448, 109 beschrieben sind.

US 4,545,967 betrifft stabilisierte Lanthan-Schwefel-Verbindungen. Die Verbindungen ergeben sich aus einer

2

Kombination von Lanthan, Schwefel und wahlweise Kalzium, Barium oder Strontium.

US 3,256,702 beschreibt Sulfide einer Reihe chemischer Elemente. Ternäre Materialien sind u. a. in Spalte 2, Zeile 48, bis Spalte 3, Zeile 9, angegeben.

US 3,940,472 betrifft quaternäre Sulfide und Selenide, die Barium oder Strontium und ausgewählte Übergangsmetalle enthalten.

Für thermoelektrische Materialien mit hohem Wirkungsgrad sind vorzugsweise noch weitere Randbedingungen zu erfüllen. Vor allem müssen sie temperaturstabil sein, um bei Arbeitstemperaturen von 1000 bis 1500 K über Jahre ohne wesentlichen Wirkungsgradverlust arbeiten zu können. Dies bedingt sowohl hochtemperaturstabile Phasen an sich, eine stabile Phasenzusammensetzung, wie auch eine zu vernachlässigende Diffusion von Legierungsbestandteilen in die anliegenden Kontaktmaterialien.

Die Aufgabe wird erfindungsgemäß gelöst durch einen thermoelektrischen Generator mit einem p- oder n-dotierten Halbleitermaterial, wobei das Halbleitermaterial ein ternäres Material aus der nachfolgenden Stoffklasse ist, das sich durch Kombination von 2 Verbindungen der Stoffklasse ergibt:

LaS, NdS, $Pr_2S_3$, DyS, USe, BaSe, GdSe, LaSe, $Nd_3Se_4$, $Nd_2Se_3$, PrSe, FrSe, UTe, GdTe, LaTe, NdTe, PrTe, SmTe, DyTe sowie ErTe

Der Anteil an Dotierungselementen beträgt bis zu 0,1 Atom-% in der Legierung oder $10^{18}$ bis $10^{20}$ Ladungsträger pro Kubikzentimeter. Höhere Ladungsträgerkonzentrationen bewirken nachteilige Rekombinationen und damit eine reduzierte Ladungsbeweglichkeit. Dotiert wird mit Elementen, die einen Elektronenüber- oder Unterschuß im Kristallgitter bewirken, z. B. mit Jodid für n-Halbleiter und Erdalkalielementen für p-Halbleiter, sofern ein 3/5- oder 3/6-Halbleiter vorliegt.

Eine weitere Möglichkeit der Dotierung ergibt sich dadurch, daß man gezielt durch unter-oder überstöchiometrische Zusammensetzungen Löcher oder Elektronen in die Materialien einbringt und sich damit einen zusätzlichen Dotierschritt erspart.

Dotierelemente können auch über die wässrigen Lösungen von Metallsalzen eingebracht werden, die anschließend in der Mischung getrocknet werden. Anschließend werden die Metallkationen z.B. durch Wasserstoff bei erhöhten Temperaturen reduziert oder verbleiben ohne Reduktion im Material. Bevorzugt erfolgt die p- oder n- Dotierung durch Wahl der Mengenverhältnisse der Verbindungen oder die p- Dotierung mit Alkalimetallen und die n- Dotierung mit Sb, Bi, Se, Te, Br, oder I (siehe WO 92/13811).

Es ist vorteilhaft, schwere Elemente einzusetzen, von denen bekannt ist, daß ihre thermische Austrittsarbeit niedrig ist. Als solche sind vor allem U, Bi, Se, Te, Ce, Ba bekannt.

Materialien im Sinne der Erfindung ergeben sich aus der Kombination von mindestens zwei Verbindungen aus den vorstehend ausgeführten Stoffklassen. Die binären Stammverbindungen zeichnen sich durch hohe Schmelzpunkte, kongruente Schmelzen und vergleichsweise hohen Seebeck - Koeffizienten aus. Zudem weisen sie alle Halbleitereigenschaften auf wie beispielsweise einen Anstieg der elektrischen Leitfähigkeit bei Temperaturerhöhung.

In der kombinatorischen Synthese und Testung werden diese binären Verbindungen eingesetzt, um aus deren Kombinationen thermoelektrische Materialien mit hohem Z - Wert zu erhalten.

Es wurde nun gefunden, daß vorzugsweise als Grundlage für thermoelektrische Materialien mit hohem Z sowie hoher Arbeitstemperatur die folgenden binären Legierungen attraktiv sind:

| Material | Schmelzpunkt (°C) |
|---|---|
| $UB_2$ | 2385 |
| $UB_4$ | 2495 |
| $UB_{12}$ | 2235 |
| $U_5Ge_3$ | 1670 |
| USb | 1850 |
| $U_3Si_5$ | 1770 |
| USe | 1990 |
| UTe | 1740 |
| BaGe | 1145 |
| BaSe | 1780 |
| $BaSi_2$ | 1180 |

Weitere geeignete binäre Materialien mit hoher Temperaturbeständigkeit - Schmelzpunkte in °C in Klammern - sind die Germanide GdGe (1790), $Dy_5Ge_3$ (1825), $Er_5Ge_3$ (1950); die Antimonide GdSb (2130), LaSb (1690), NdSb (2100), PrSb (2170), DySb (2170); die Plumbide CePb (1380), $Gd_5Pb_3$ (1670), $La_5Pb_3$ (1450), $Dy_{,5}Pb_4$ (1695); die Silizide GdSi (2100), $NdSi_2$ (1757), die Selenide GdSe (2170), LaSe (1950), $Nd_3Se_4$, $Nd_2Se_3$, PrSe (2100), ErSe (1630);

die Telluride GdTe (1825), LaTe, (1720), NaTe (2025), PrTe (1950), SmTe (1910), DyTe (1850), ErTe (1790) sowie die Sulfide LaS (2300), NdS (2200), $Pr_2S_3$ (1795) und DyS (2370).

| Weiterhin: | |
|---|---|
| $CeB_6$ | 2550 |
| $Ce_3Ge_5$ | 1513 |
| $CeSb$ | 1800 |
| $CeSi_2$ | 1430 |
| $CeTe$ | 1820 |
| $Ce_4Bi_3$ | 1740 |
| $CePb$ | 1380 |

Aus diesen leiten sich die folgenden bevorzugten ternären Materialien ab, wobei x von 0,01 bis 0,99 vorzugsweise von 0,05 bis 0,95 beträgt:

$U_{1+4x}B_{2-2x}Ge_{3x}$

$USb_xB_{2-2x}$

$U_{1+2x}B_{2-2x}Si_{5-x}$

$UB_{2-2x}Si_x$

$UB_{2-2x}Te_x$

$U_xBa_{1-x}Se$

$(U_xBa_{1+x})_5 Ge_{5-2x}$

$(U_xBa_{1-x})_3 Si_{6-x}$

$U_xCe_{1-x}B_{6+6x}$

$U_{5-5x}Ce_{3x}Ge_{3+2x}$

$U_xCe_{1-x}Sb$

$U_{3-3x}Ce_xSi_{5-3x}$

$U_xCe_{1-x}Te$

$U_{3-2x}Si_{5-5x}Se_x$

$U_{3-2x}Si_{5-5x}Te_x$

$U_{3-3x}Ba_xSi_{5-3x}$

$USb_xTe_{1-x}$

$USb_xSe_{1-x}$

$USe_xTe_{1-x}$

$U_xBa_{1-x}Se$

$U_xCe_{1-x}Te$

$Ba_xCe_{3-3x}Ge_{5-4x}$

$BaSe_xSi_{2-2x}$

$BaCe_{1-x} Si_2$

$Se_xGe_{1-x} Ba$

$Se_xSi_{2-2x} Ba$

$(U_xGd_{1+x})_5 Ge_{5-2x}$

$(U_xDy_{1-x})_5 Ge_3$

$(U_xEr_{1-x})_5 Ge_3$

$U_xGd_{1-x}Sb$

$U_xLa_{1-x}Sb$

$U_xNd_{1-x}Sb$

$U_xPr_{1-x}Sb$

$U_xDy_{1-x}Sb$

$U_{3-3x}Gd_xSi_{5-4x}$

$U_{3-3x}Nd_xSi_{5-3x}$

$U_{3-3x}Pr_xSi_{5-3x}$

$U_xGd_{1-x}Se$

$U_xLa_{1-x}Se$

$U_{3-3x}Nd_{3x} Se_{x+3}$

$U_xPr_{1-x}Se$

$U_xEr_{1-x}Se$

$U_xGd_{1-x}Te$

$U_xLa_{1-x}Te$

$U_xNd_{1-x}Te$

$U_xPr_{1-x}Te$

$U_xSm_{1-x}Te$

$U_xDy_{1-x}Te$

$U_xEr_{1-x}Te$

$Ba_xGd_{1-x}Ge$

$Ba_{1-x}Dy_{5x}Ge_{2x+1}$

$Ba_{1-x}Er_{5x}Ge_{2x+1}$

$Ba_xGd_{1-x}Se$

$Ba_xLa_{1-x}Se$

$Ba_{1-x}Nd_{3x}Se_{3x+1}$

$Ba_{1-x}Nd_{2x}Se_{2x+1}$

$Ba_xPr_{1-x}Se$

$Ba_xEr_{1-x}Se$

$Ba_xGd_{1-x}Si_{x+1}$

$Ba_xNd_{1-x}Si_2$

$Ba_xPr_{1-x}Si_2$

$Ce_{3x}Gd_{1-x}Ge_{4x+1}$

$Ce_{3-3x}Dy_{5x}Ge_{5-2x}$

$Ce_{3-3x}Er_{5x}Ge_{5-2x}$

$Ce_xGd_{1-x}Sb$

$Ce_xLa_{1-x}Sb$

$Ce_xNd_{1-x}Sb$

$Ce_xPr_{1-x}Sb$

$Ce_xDy_{1-x}Sb$

$Ce_xGd_{5-5x}Pb_{3-2x}$

$Ce_xLa_{5-5x}Pb_{3-2x}$

$Ce_xDy_{5-5x}Pb_{4-3x}$

$Ce_xGd_{1-x}Si_{x+1}$

$Ce_xNd_{1-x}Si_2$

$Ce_xPr_{1-x}Si_2$

$Gd_xDy_{5-5x}Ge_{3-2x}$

$Gd_xEr_{5-5x}Ge_{3-2x}$

$Gd_xLa_{1-x}Sb$

$Gd_xNd_{1-x}Sb$

$Gd_xPr_{1-x}Sb$

$GdxDy_{1-x}Sb$

$Gd_xDy_{1-x}Sb$

$(Gd_xLa_{1-x})_5Pb_3$

$(Gd_xDy_{1-x})_5Pb_{4-x}$

$Gd_xNd_{1-x}Si_{2-x}$

$Gd_xPr_{1-x}Si_{2-x}$

$Gd_xLa_{1-x}Se$

$Gd_{1-x}Nd_{3x}Se_{3x+1}$

$Gd_{1-x}Nd_{2x}Se_{2x+1}$

$Gd_xPr_{1-x}Se$

$Gd_xEr_{1-x}Se$

$Gd_xLa_{1-x}Te$

$Gd_xNd_{1-x}Te$

$Gd_xPr_{1-x}Te$

$Gd_xSm_{1-x}Te$

$Gd_xDy_{1-x}Te$

$Gd_xEr_{1-x}Te$

$La_xNd_{1-x}Sb$

$La_xPr_{1-x}Sb$

$La_xDy_{1-x}Sb$

$(La_xDy_{1-x})_5Pb_{4-x}$

$La_{1-x}Nd_{3x}Se_{3x+1}$

$La_{1-x}Nd_{2x}Se_{2x+1}$

$La_xPr_{1-x}Se$

$La_xEr_{1-x}Se$

$La_xNd_{1-x}Te$

$La_xPr_{1-x}Te$

$La_xEr_{1-x}Te$

$La_xDy_{1-x}Te$

$La_xSm_{1-x}Te$

$La_xNd_{1-x}S$

$La_xDy_{1-x}S$

$La_{1-x}Pr_{2x}S_{2x+1}$

$Nd_xPr_{1-x}Sb$

$Nd_xDy_{1-x}Sb$

$Nd_xPr_{1-x}Si_2$

$Pr_{1-x}Nd_{3x}Se_{3x+1}$

$Pr_{1-x}Nd_{2x}Se_{2x+1}$

$Er_{1-x}Nd_{3x}Se_{3x+1}$

$Er_{1-x}Nd_{2x}Se_{2x+1}$

$Nd_xPr_{1-x}Te$

$Nd_xSm_{1-x}Te$

$Nd_xDy_{1-x}Te$

$Nd_xEr_{1-x}Te$

$Nd_xDy_{1-x}S$

$Nd_{1-x}Pr_{2x}S_{2x+1}$

$Pr_2Dy_{1-x}Sb$

$Pr_xEr_{1-x}Se$

$Pr_xSm_{1-x}Te$

$Pr_xDy_{1-x}Te$

$Pr_xEr_{1-x}Te$

$Pr_{2x}Dy_{1-x}S_{2x+1}$

$Sm_xDy_{1-x}Te$

$Sm_xEr_{1-x}Te$

$(Dy_xEr_{1-x})_5Ge_3$

$Dy_xEr_{1-x}Te$

Besonders preiswerte thermoelektrische Materialien sind halbleitende Silizide und Boride mit hohen Si- oder B- Gehalten der Form

Me $Si_x$ mit $x \geq 1$

sowie

Me $B_x$ mit $x \geq 1$

Diese werden mit Alkalimetallen p- dotiert, mit Sb, Bi, Se, Te, Br oder J n- dotiert.

Die Erfindung betrifft auch die vorstehend beschriebenen Halbleitermaterialien. Die Erfindung betrifft auch ein Verfahren zur Herstellung dieser Halbleitermaterialien durch Sintern oder Zusammenschmelzen und nachfolgend Sintern von Mischungen der Elementpulver oder Sintern von Mischungen der Oxidpulver.

Die erfindungsgemäßen Materialien werden somit nach bekannten Verfahren hergestellt, die Elementverbindungen z.B. durch Sintern der Elementpulver bei hohen Temperaturen, jedoch unterhalb des Schmelzpunkts oder durch Lichtbogenschmelzen im Hochvakuum sowie anschließendes Pulverisieren und Sintern. Die Oxide werden z.B. durch Sintern der Pulvermischungen der Einzeloxide synthetisiert. Der Ausdruck "Kombination", wie er vorstehend benutzt wurde, bezieht sich gerade auf diese Herstellung, insbesondere das Sintern.

Die erfindungsgemäßen Materialien werden gemäß dem Stand der Technik, wie er z. B. in WO 98/44562, US 5, 448, 109 oder US 5, 439, 528 dargestellt ist, in Module eingebracht und in diesen in Serie geschaltet.

**Patentansprüche**

1. Thermoelektrischer Generator mit einem p- oder n-dotierten Halbleitermaterial, **dadurch gekennzeichnet, dass** das Halbleitermaterial ein ternäres Material aus der nachfolgenden Stoffklasse ist, das sich durch Kombination von 2 Verbindungen der Stoffklasse ergibt:
   LaS, NdS, $Pr_2S_3$, DyS, USe BaSe, GdSe, LaSe, $Nd_3Se_4$, $Nd_2Se_3$, PrSe, FrSe, UTe, GdTe, LaTe, NdTe, PrTe, SmTe, DyTe sowie ErTe.

2. Thermoelektrischer Generator nach Anspruch 1, **dadurch gekennzeichnet, dass** die poder n-Dotierung durch Wahl der Mengenverhältnisse der Verbindungen oder die p-Dotierung mit Alkalimetallen und die n-Dotierung mit Sb, Bi, Se, Te, Br, oder I erfolgt.

3. Halbleitermaterial, wie es in einem der Ansprüche 1 oder 2 definiert ist.

4. Verfahren zur Herstellung von Halbleitermaterialien gemäß Anspruch 3 durch Sintern oder Zusammenschmelzen und nachfolgend Sintern von Mischungen der Elementpulver.

**Claims**

1. A thermoelectric generator comprising a p-doped or n-doped semiconductor material, wherein said semiconductor material is a ternary material selected from the following substance class and formed by combining 2 compounds of the substance class:
   LaS, NdS, $Pr_2S_3$, DyS, USe, BaSe, GdSe, LaSe, $Nd_3Se_4$, $Nd_2Se_3$, PrSe, FrSe, UTe, GdTe, LaTe, NdTe, PrTe, SmTe, DyTe and ErTe.

2. A thermoelectric generator according to claim 1, wherein p-type doping or n-type doping is achieved by selecting the mixing ratios of the compounds or p-type doping is achieved by means of alkali metals and n-type doping is achieved by means of Sb, Bi, Se, Te, Br or I.

3. A semiconductor material as defined in either of claims 1 and 2.

4. A process for the preparation of semiconductor materials according to claim 3 by sintering or melting together and subsequently sintering mixtures of the elemental powders.

**Revendications**

1. Générateur thermoélectrique présentant un matériau semi-conducteur dopé P ou N, **caractérisé en ce que** le matériau semi-conducteur est un matériau ternaire de la classe de substances suivante, obtenu par combinaison de 2 composés de la classe de substances :
   LaS, NdS, $Pr_2S_3$, DyS, Use, BaSe, GdSe, LaSe, $Nd_3Se_4$, $Nd_2Se_3$, PrSe, FrSe, UTe, GdTe, LaTe, NdTe, PrTe, SmTe, DyTe ainsi que ErTe.

2. Générateur thermoélectrique selon la revendication 1, **caractérisé en ce que** le dopage P ou N est réalisé par le choix des rapports des quantités des composés ou le dopage P avec des métaux alcalins et le dopage N avec Sb, Bi, Se, Te, Br ou I.

3. Matériau semi-conducteur tel qu'il est défini dans l'une quelconque des revendications 1 ou 2.

4. Procédé pour la production de matériaux semiconducteurs selon la revendication 3 par frittage ou fusion et frittage consécutif de mélanges des poudres élémentaires.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5448109 A
- US 4545967 A
- US 3256702 A
- US 3940472 A
- WO 9213811 A
- WO 9844562 A
- US 5439528 A

**In der Beschreibung aufgeführte Nicht-Patentliteratur**

- **B. Cronin ; B. Vining.** ITS Short Course on Thermo-electricity. Yokohama, 08. November 1993
- *Mat. Sci. and Eng.,* 1995, vol. B29, 228